# EUROPÄISCHE PATENTSCHRIFT

(11) **EP 2 034 039 B1**
(45) Veröffentlichungstag und Bekanntmachung des Hinweises auf die Patenterteilung: **20.06.2012**
(21) Anmeldenummer: 08019431.9
(22) Anmeldetag: 09.08.2001
(51) Int. Cl.: C23C 14/02, C23C 14/04, H05K 3/04, G06K 19/077, H01Q 1/22

(54) **Metallisierte Folie und Verfahren zu deren Herstellung sowie deren Anwendung**
Metallic film and method of its manufacture and use
Film métallisé et son procédé de fabrication et d'utilisation

(30) Priorität: 09.10.2000 DE 20017392 U
(43) Veröffentlichungstag der Anmeldung: 11.03.2009
(62) Teilanmeldung aus: 01960161.6
(73) Patentinhaber: Hueck Folien Ges.m.b.H., 4342 Baumgartenberg (AT)
(72) Erfinder: Kastner, Friedrich, 4710 Grieskirchen (AT); Bergsmann, Dr. Martin, 4020 Linz (AT); Hillburger, Johann, 92712 Pirk (DE); Einsiedler, Ronald, 4020 Linz (AT); Treutlein, Roland, 92712 Pirk (DE)
(74) Vertreter: Hagemeier, Annette

(56) Entgegenhaltungen:
- EP-A- 0 475 145
- WO-A-99/19152
- US-A- 4 354 911
- US-A- 4 402 998
- US-A- 4 622 106

## Beschreibung

Die Erfindung betrifft ein Verfahren zur Herstellung einer metallisierten Folie.

Aus der WO 99/13157 sind beispielsweise Sicherheitsfolien für Wertpapiere und Verfahren zu ihrer Herstellung bekannt. Eine solche Sicherheitsfolie zur Einlagerung oder Aufbringung in bzw. auf Wertpapiere besteht aus einer transluzenten Trägerfolie und einer darauf aufgebrachten metallischen Beschichtung, die metallfreie Bereiche aufweist, die insbesondere im Durchlicht klar zu erkennen sind. Zur Herstellung dieser metallisierten Folien wird die Trägerfolie bereitgestellt, dann die Trägerfolie mit einer Druckfarbe mit hohem Pigmentanteil bedruckt, dann die Druckfarbe zur Bildung eines porigen, erhabenen Farbauftrages getrocknet, auf der so bedruckten Trägerfolie dann eine dünne metallische Abdeckschicht gebildet, dann der Farbauftrag und die darüber liegende bzw. in den Farbauftrag eingedrungene Abdeckschicht durch Auswaschen mit einer Flüssigkeit, eventuell kombiniert mit mechanischer Einwirkung, entfernt, und schließlich die Trägerfolie getrocknet und ggf. zugeschnitten. Auf der Trägerfolie verbleibt somit in den ursprünglich nicht mit der Druckfarbe versehenen Bereichen die metallische Abdeckschicht, die laut der Veröffentlichung eine Dicke von 0,01 µm bis 1 µm haben kann.

Aus der EP 0 330 733 A1 ist ein Sicherheitselement in Form eines Fadens aus einer lichtdurchlässigen Kunststoffolie bekannt, das eine sich über das Element erstreckende opake Beschichtung mit Aussparungen in Form der einzubringenden Zeichen und Muster aufweist und bei dem zumindest in den zu den Aussparungen deckungsgleichen Bereichen farbgebende und/oder lumineszierende Substanzen enthalten sind, durch die sich die Zeichen und/oder Muster unter geeigneten Lichtbedingungen vom Sicherheitsdokument und von der opaken Beschichtung in farblich kontrastierender Form unterscheiden.

In der DE 36 87 250 T2 wird ein Verfahren zur Herstellung metall-beschichteter dielektrischer Träger beschrieben, bei dem auf ein dimensionsbeständiges Polyimid-Substrat unter Vakuumbedingungen eine Schicht aus metallischem Chrom aufgedampft wird und anschließend auf diese Chromschicht galvanisch eine Kupferschicht aufgebracht wird. Um ein gewünschtes Muster auf den Kupferleiterbahnen zu erzeugen, wird die Kupferschicht geätzt und dann eine Schicht aus Gold oder Zinn oder einem Lötmittel auf diesen Leiterbahnen aufgebracht.

Die DE 36 10 379 A1 offenbart ein Verfahren zur Herstellung einer auf mindestens einer ihrer Oberflächen mit einer an vorgewählten Punkten unterbrochenen Metallschicht vorgesehenen Folie. Bei diesem Verfahren wird die Metallschicht an den vorgewählten Stellen auf eine schlecht haftende Unterlage aufgebracht und an den vorgewählten Stellen mechanisch abgetragen. Auf diese Weise kann die schlecht haftende Unterlage über die gesamte Oberfläche der Folie so verteilt werden, dass sich daraus das gewünschte Muster ergibt. Unabhängig von diesem Muster wird dann die gesamte Oberfläche metallisiert, so dass die Metallisierung relativ billig durchgeführt werden kann. Da die Metallschicht auf der schlecht haftenden Oberfläche nur lose aufgebracht ist, kann sie relativ einfach mit mechanischen Mitteln von der Oberfläche gelöst werden.

Weitere metallisierte Folien und Verfahren zu deren Herstellung sind beispielsweise aus der EP 0107983A1, EP 0479058A1, EP 0600374A1, DE 19834348A1, DE 19815175A1, DE 19812932A1, DE 19643823A1, DE 19718177A1, DE 19729891A1, DE 19822075A1, DE 19818968A1, US 4,242,378, US 4,685,997 und US 4,863,808 bekannt. Zur Vermeidung von bloßen Wiedergaben der jeweiligen Offenbarungsgehalte sind letztere hiermit durch Bezugnahme vollumfänglich in die vorliegenden Unterlagen aufgenommen, insbesondere hinsichtlich der Strukturen, Schichtdicken und Materialien der metallisierten Folien sowie der Verfahrensschritte zur Erzeugung von Mustern mit der metallischen Schicht.

Während es bei einigen Anwendungen von metallisierten Folien grundsätzlich wünschenswert sein kann, für bestimmte Anwendungen, wie beispielsweise Sicherheitsfolien für Wertpapiere, die metallische Schicht möglichst dünn zu halten, damit sie möglichst wenig aufträgt, erfordern andere Anwendungen dickere und dennoch sauber strukturierte oder geformte metallische Schichten mit feiner Musterung, die mit den bekannten Verfahren nicht in befriedigender Weise hergestellt werden können, wie z.B. für Leiterbahnen oder Leiterplatten, insbesondere für Antennen, wie man sie beispielsweise in Handys findet.

Die vorliegende Erfindung hat zum Ziel, ein Verfahren zur Herstellung einer metallisierten Folie zu schaffen, wobei die Folie strukturierte Schichten aus den verschiedensten Metallen, Metallverbindungen oder Legierungen auf einer oder beiden Seiten eines Trägermaterials aufweist. Weiterhin sollen diese strukturierten Schichten passergenau herstellbar sein, um damit beispielsweise Leiterbahnen oder dergleichen bauen zu können.

Erfindungsgemäß besteht eine solche metallisierte Folie gemäß einer Variante der vorliegenden Erfindung aus einem Substrat oder einer Trägerfolie, auf dem oder auf der eine oder mehrere strukturierte dünne metallische Schicht(en) aufgebracht, im allgemeinen aufgedampft ist/sind, wobei das Substrat oder die Trägerfolie vor der Metallisierung durch Reinigung und Bekeimung vorbehandelt wird.

Auf der dünnen metallischen Schicht kann ggf. eine dickere metallische Verstärkungsschicht vorhanden sein, wobei die Verstärkungsschicht gemäß der vorliegenden Erfindung vorzugsweise durch chemischen oder galvanischen Materialauftrag hergestellt wird, um so eine Nachverstärkung der Musterschicht mit Material zu erreichen. Dies ist dann erforderlich, wenn Schichten von mehr als 1 µm erreicht werden sollen, da diese Schichtdicken nur unter erheblichem Aufwand durch Vakuumbedampfen erreicht werden. Die Verstärkungsschicht weist jedoch dasselbe Muster wie die Musterschicht auf, wobei ein geringfügiges Hinausgehen der Verstärkungsschicht über die Musterschicht noch im Rahmen der Erfindung liegt.

Bei dem erfindungsgemäßen Verfahren zur Herstellung der metallisierten Folie wird zunächst das Trägermaterial gereinigt und bekeimt. Dieser Verfahrensschritt ist Voraussetzung für eine gute Haftung der partiell strukturiert aufgebrachten Schicht zum Substrat. Auch im Fall einer Mehrschichtbedampfung ist dieser Schritt Voraussetzung, um die gute Haftung der Schichten untereinander zu gewährleisten. Hier bildet dieser Verfahrensschritt die Basis für die Herstellung feinst strukturierter Schichten.

Vor der eigentlichen funktionalen Schicht wird ein(e)in einem beliebigen Lösungsmittel, z.B. Wasser, Alkohole, Ketone, Ester lösliche Farbe, mit oder ohne Pigmentierung mittels Tiefdruck, Flexodruck, Siebdruck, Digitaldruck oder ähnlichen Druckverfahren, aufgebracht und anschließend eine Schicht des zu strukturierenden Materials in eine Stärke von 0,001 µm bis 50 µm durch Bedampfen, Sputtern, Drucken, Lackieren, Sprühen und ähnlichen Methoden aufgebracht. Bei wasserlöslichen Systemen können z.B. Stärke, Casein, PVA oder sonstige wasserlösliche Bindemittel oder Mischungen derselben eingesetzt werden. Falls Pigmente eingesetzt werden, können z.B. TiOₓ, SiOₓ, ZnS, AlₓO_{y} oder ähnliche Substanzen oder Mischungen mit unterschiedlichen Korngrößenverteilungen zugesetzt werden. Die Löslichkeit der jeweils gedruckten Struktur ist für dieses Verfahren von Bedeutung. Im allgemeinen werden wasserlösliche Farben verwendet, es können aber auch auf alle denkbaren Lösungsmittel abgestimmte Farben verwendet werden. Den Farben können Pigmente beigefügt werden, wodurch sich die Waschbarkeit im Löse- und mechanischen Waschvorgang stark verbessert. Um ein Anlösen der abgedeckten Farbschicht weiter zu verbessern, kann auch vollflächig oder passergenau eine dünne ca. 0,01 µm bis 0,5 µm dicke, pigmentierte Farbschicht, eine reine Pigmentschicht oder Pigmente in Suspension aufgebracht werden. Bei den verwendeten Pigmenten handelt es sich im allgemeinen um ZnS, TiO₂, es können jedoch auch alle anderen bekannten Pigmente verwendet werden.

Wie bereits weiter oben ausgeführt, ist die Vorbehandlung des Substrats durch den Reinigungs- und Bekeimungsschritt Voraussetzung für eine gute Haftung. Um dies zu erreichen, insbesondere um die Haftung des Materials zu verbessern, kann das bedruckte Substrat mittels eines INLINE Plasma- oder Coronaprozesses vorbehandelt werden. Durch diese Vorbehandlung wird die Folienoberfläche von Tonungsresten der Druckfarben befreit und gleichzeitig aktiviert, da endständige polare Gruppen erzeugt werden. Darüber hinaus kann zeitgleich mit der Plasmavorbehandlung im Vakuum auch eine dünne Metall- oder Metalloxidschicht als Haftvermittler durch Sputtern oder Aufdampfen aufgebracht werden. Hierzu eignen sich insbesondere Cr, Al, Ag, Ni, Cu, Ti, TiO₂, SiOₓ, CrOₓ.

Die metallischen Schichten können im Rahmen des erfindungsgemäßen Verfahrens partiell oder vollflächig auf dem Substrat oder der Trägerfolie aufgebracht sein.

Gemäß einer Variante des erfindungsgemäßen Verfahrens wird eine partielle metallische Schicht, dadurch erzeugt, dass das Trägermaterial zunächst mit einer löslichen Farbe oder einem Lack bedruckt wird, sich dann der Reinigungs- und Bekeimungsschritt anschließt und anschließend bspw. eine Cu-Schicht zur Bildung der Musterschicht auf der Trägerfolie aufgebracht wird. Dann wird die Farbe durch einen mechanischen Waschvorgang entfernt, um die gewünschte Strukturierung zu erhalten. Darauf folgt ggf. eine galvanische Nachverstärkung dieser Musterschicht unter Bildung der Verstärkungsschicht darauf.

Außerdem ist es möglich mit dem erfindungsgemäßen Verfahren eine metallisierte Folie mit einem Mehrschichtaufbau (Multilayer) bereitzustellen. Dabei kann der Mehrschichtaufbau durch vollflächig übereinander aufgebrachte Schichten verschiedener Materialien sein. Durch die Kombination von Schichten mit unterschiedlichen physikalischen Eigenschaften, z.B. unterschiedlicher Leitfähigkeit, Magnetisierbarkeit, Absorptionsverhalten, Schirmung, Barriere, bzw. optischen Effekten in einem Produkt sind die Multilayer-Produkte vielfältig einsetzbar.

Andererseits können durch mehrfache Anwendung des Verfahrens zur Schichtstrukturierung sowie durch passergenauen Druck im Längs- und Seitenregister zur vorherigen Strukturierung funktionelle Mehrschichtsysteme aufgebaut werden, insbesondere können zwischen den einzelnen Schichten auch partielle oder vollflächige Lack- und Folienschichten aufgebracht sein.

Prinzipiell sind durch das erfindungsgemäße Verfahren beliebig viele Schichten realisierbar. Je nach weiterer Anwendung kann das Produkt mit einem siegelfähigen Kleber (Heiß- oder Kaltsiegelkleber) ausgestattet sein und ähnlich einer Heißprägefolie auf verschiedene Trägersubstrate appliziert sein. Die Trägerfolie kann dann nach der Anwendung entfernt werden oder verbleibt am Produkt. Im letzteren Fall kann die Trägerfolienrückseite noch eine zusätzliche Ausrüstung, wie kratzfeste oder antistatische Eigenschaften erhalten. Durch weiterführende Prozeßschritte können die Multilayer-Systeme veredelt werden, hier bietet sich insbesondere eine weiterführende Kaschierung an.

Auch bei der Herstellung der metallisierten Folie mit einem Mehrschichtaufbau ist eine wesentliche Voraussetzung zur Verbesserung der Haftung der aufgedampften Metallschichten untereinander der Schritt der Plasmavorbehandlung unter gleichzeitiger Sputterbekeimung mit ebenfalls dem gleichen Metall in jedem Aufdampfschritt der Mehrschichtbedampfung gleichen Materials. Bei der Mehrschichtbedampfung mit unterschiedlichen Materialien wird die bereits bestehende Schicht analog vorbehandelt.

Nachfolgend werden Ausführungsformen der Erfindung anhand der beigefügten Zeichnungen erläutert. Es zeigen:
- Fig. 1: eine schematische Darstellung eines Schnitts durch einen Schichtaufbau einer partiell bedampften metallischen Folie im Herstellungsstadium;
- Fig. 2: eine schematische Darstellung eines Schnittes durch das fertige Endprodukt einer partiell bedampften metallischen Folie;
- Fig. 3: eine schematische Darstellung eines Schnittes durch das fertige Endprodukt eines vollflächigen Mehrschichtenaufbaus;
- Fig. 4: eine schematische Darstellung eines Schnittes durch das fertige Endprodukt eines partiell bedampften Mehrschichtenaufbaus.

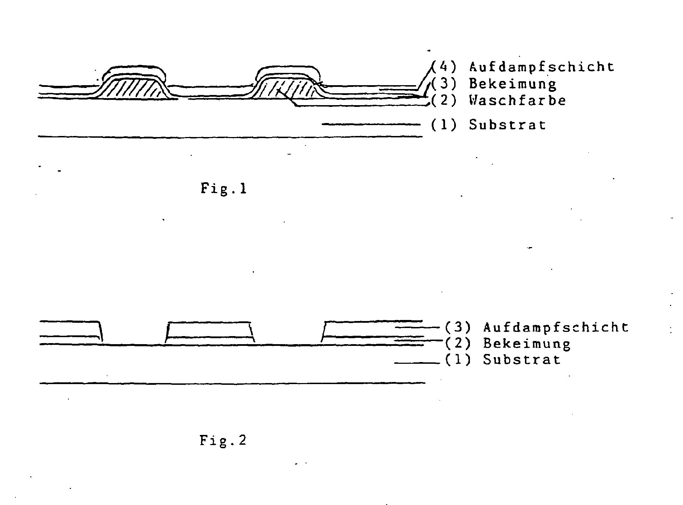

Wie in Fig. 1 gezeigt, wird für die Herstellung einer partiell bedampften metallischen Folie zunächst ein Substrat oder eine Trägerfolie (1) bereitgestellt. Auf dieses Substrat wird eine lösliche Farbe (Waschfarbe) (2) aufgetragen. Dieses bedruckte Substrat oder diese bedruckte Folie wird durch einen Reinigungs- und Bekeimungsvorgang vorbehandelt, wodurch eine Bekeimungsschicht (3) zur besseren Haftung der metallischen Schicht erzeugt wird, dann wird die metallische Schicht (4) aufgedampft.

Fig. 2 zeigt die partiell bedampfte metallische Folie als Endprodukt, bei dem die Lösliche Farbe (Waschfarbe) durch einen mechanischen Waschvorgang entfernt wurde und die zeigt, dass nach Lösen der löslichen Farbe (Waschfarbe) die aufgedampfte metallische Schicht (3) samt Bekeimung (2) partiell auf dem Substrat(1) gebildet wurde.

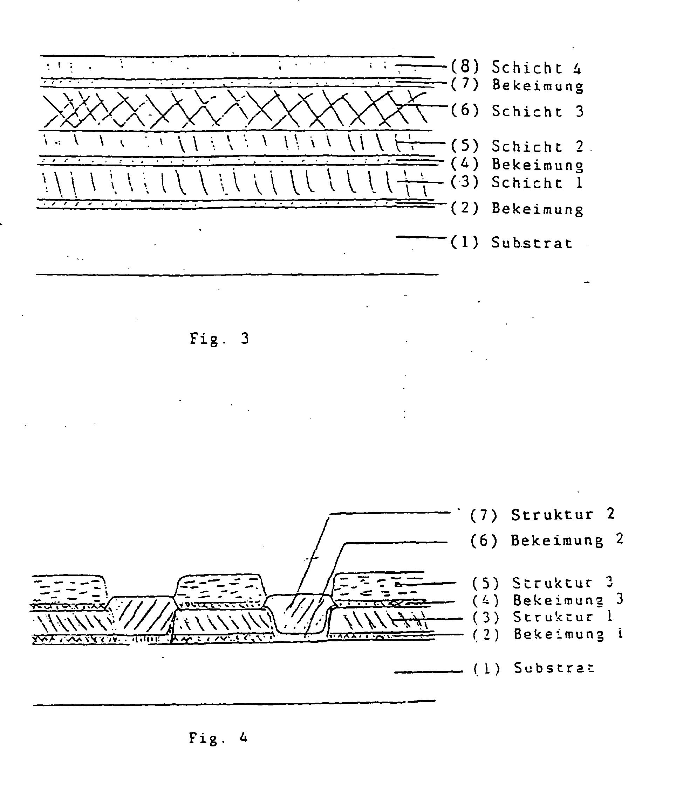

Wie in Fig. 3 gezeigt, wird für Herstellung einer metallischen Folie mit einem Mehrschichtenaufbau ein Substrat (1) verwendet, das einer Bekeimungsschicht (2) versehen ist, die durch den oben beschriebenen Plasmareinigungsprozeß mit gleichzeitiger Bekeimung erzeugt wurde. Auf diese Bekeimungsschicht (2) wird dann die Metallschicht (3) aufgedampft. Die Schritte der Bekeimung und der Metallbedampfung werden so oft wiederholt, wie es für das fertige Endprodukt gewünscht ist. Dabei können alle Bekeimungsschichten aus dem gleichen Material oder aus unterschiedlichen Materialien sein und genauso können die Metallschichten jeweils aus gleichen oder unterschiedlichen Materialien sein. Außerdem können eine oder mehrere Schichten dieses Aufbaus auch aus nichtmetallischen Substanzen, die oben erwähnt sind, bestehen. In dem hier gezeigten Beispiel wurden vier Bekeimungs- und Aufdampfschritte durchgeführt.

Je nach Anwendung kann dieser vollflächige Aufbau aus Fig. 3 bereits dem Endprodukt entsprechen, wie es z.B. für optische Beschichtungen für Reflexionsschichten verwendet wird, wo durch den Schichtaufbau und die Anzahl der Schichten die Wellenlängenbereiche für Reflexion einstellbar sind. Das Endprodukt würde dem in Fig. 2 gezeigten, allerdings mit mehreren übereinander liegenden Bekeimungs- und Aufdampfschichten entsprechen.

Fig. 4 zeigt eine andere Ausführungsform des Mehrschichtenaufbaus, bei der ein Substrat (1) bekeimt wird und die Struktur 1 (3), wie auch schon in Fig. 2 beschrieben, erzeugt wird. Nach Strukturierung der Schicht (3) zur Struktur 1 wird lösliche Farbe (Waschfarbe) passergenau in die beim ersten Verfahrenszyklus unbedruckten aufgedruckt, danach wird wieder bekeimt (6) (Bekeimung 2) und beschichtet(7) und die Schicht zur Struktur 2 strukturiert (7). Dann wird erneut die Struktur 1 mit einer löslichen Farbe versehen, bekeimt (4) und strukturiert (5), wobei die Struktur 3 hergestellt wird. Dieser Vorgang kann mehrmals, im Prinzip beliebig oft, wiederholt werden. Dadurch wird es z.B. möglich, dass zwei Strukturen aus unterschiedlichen Materialien in derselben Ebene definiert herstellt werden können, wo sich die Struktur 2 (6) genau in den Bereichen befindet, die bei der Erzeugung von Struktur 1 (3) entfernt wurden.

Die metallisierten Folien werden für daraus hergestellte RF- (Radiofrequenz) Antennen insbesondere für Transponder verwendet. Sie eignen sich insbesondere als Smart Cards, die als kontaktlose Systeme, z. B. für Zutrittsberechtigungen im öffentlichen Personennahverkehr, in Skigebieten als Skipässe, oder für Sicherheitsschleusen, Verwendung finden, die aber auch für Kreditkarten oder Kundenkarten, sowie im Flugverkehr als bspw. Miles & More-Karten eingesetzt werden können. Weiterhin können sie als Smart Labels als kontaktlos lesbare und beschreibbare Alternative zum Barcode beispielsweise für Paketdienste, Bibliotheken und im Einzelhandel verwendet werden. Auch ist ein Einsatz als Tags möglich, wie sie in Flughäfen als Kofferanhänger verwendet werden.

Als RF-Antennen können sie auch als Diebstahletiketten eingesetzt werden, wobei eine RF-Antenne mit einem Kondensator (gedruckt oder bestückt) kombiniert wird, so dass ein Signal beim Verlassen eines Geschäfts ausgelöst wird, wenn das System nicht deaktiviert wurde.

Außerdem ist ein Einsatz als Kontrolletikett für Qualitätskontrollen denkbar, wobei die RF-Antenne ebenfalls mit einem Kondensator (gedruckt oder bestückt) kombiniert wird. So kann bei der Endkontrolle bspw. von Fahrzeugen mittels verschiedener Frequenzen ein akustisches Signal abgefragt werden, ob bestimmte "nichtsichtbare" Bauteile im Fahrzeug eingebaut wurden, wobei die Etiketten auf den jeweiligen Bauteilen nur auf eine bestimmte Frequenz reagieren.

Die metallisierten Folien können auch als Flachantennen als platz- und gewichtssparende Antennen für Handys eingesetzt werden, wobei sie dann im Handy-Gehäuse integriert werden. Dies bietet insbesondere den Vorteil, dass eine effektive Schirmung der Antenne auf der körperzugewandten Seite möglich ist und dadurch die Strahlenbelastung vermindert wird. Außerdem kann eine schnellere Datenübertragung in der WAP-Technologie erreicht werden.

Die metallisierten Folien können auch in Planarantennen als Alternative zum Parabolspiegel in der Unterhaltungselektronik eingesetzt werden oder als alternative Empfangseinheit in der Wissenschaft.

Eine weitere Verwendungsmöglichkeit der erfindungsgemäßen Folien ist der Einsatz im Bereich Leiterplatten als kleberloses Basismaterial. Hier besteht der Vorteil, dass beispielsweise zwischen einer Cu-Schicht und einer PI-Folie keine störende Kleberschicht vorhanden ist, die üblicherweise bei der für die Leiterplattenfertigung eingesetzten Basismaterialien zwischen der Cu-Schicht und der PI-Folie als eine ca. 10 µm bis 15 µm dicke Kleberschicht vorhanden ist, die sich störend für die weitere Verarbeitung auswirkt und die Herstellung von Feinstleiterplatten nahezu unmöglich macht.

Darüber hinaus können die metallisierten Folien in Leiterplatten verwendet werden, die nur Signalströme zu leiten haben und mit dem erfindungsgemäßen Herstellungsverfahren kostengünstig, etwa 90 % billiger als mit den bekannten Verfahren, hergestellt werden können. Dies sind insbesondere Leiterplatten, aus denen Sensorelemente für verschiedene Anwendungsbereiche, wie zum Beispiel Fernbedienungen gebaut werden. Dabei können die Sensorelemente nach den physikalischen Prinzipien kapazitiv, induktiv, leitfähig, über Wärme oder Druck arbeiten.

Ein besonders interessantes Einsatzgebiet der erfindungsgemäß metallisierten Folien ist im Bereich der Schirmung für EMV-gefährdete Räume und Baugruppen zu finden. Insbesondere bei höheren Frequenzen werden mit metallisierten Folien ausgezeichnete Schirmdämpfungen erreicht. Mit den metallisierten bedampften Kunststoffolien können wirkungsvoll und sehr preiswert elektrische Schirmungen hergestellt werden, die geeignet sind, die EMV-Problematik zu reduzieren bzw. zu beseitigen. Sie können insbesondere in Motorengehäusen, Handyschalen, Leiterplatten und Sensoren Anwendung finden.

Außerdem sind die metallisierten Folien als Faden, Streifen oder Patch für Banknoten, Wertpapiere und Kreditkarten verwendbar.

In einer bevorzugten Ausführungsform der Erfindung wird bei der Herstellung der Musterschicht zunächst ein das Muster begrenzendes Druckbild durch Tiefdruck hergestellt. Um zu vermeiden, dass es bei der Verwendung von löslicher Farbe (Waschfarbe) zu einer Tonung der Farbe kommt, weil das Farbbindemittel breiter als der eigentliche Druck verläuft und zusätzlich das Bindemittel durch das Rakel auch in nicht zu bedruckende Bereiche verschleppt werden kann, wird vorzugsweise vor der Metallisierung der INLINE-Plasmaprozeß eingesetzt. Durch energiereiches, z.B. Argon oder Argon-/Sauerstoff-Plasma, wird eine Farbtonung vor der Metallisierung entfernt, also sozusagen eine Plasma-Reinigung der bedruckten Trägerfolie durchgeführt. Als weiterer Vorteil aktiviert das Plasma zusätzlich die Folienoberfläche der Trägerfolie und schafft polare endständige Gruppen an dieser Oberfläche, was zusätzlich zu einer Verbesserung der Metallhaftung führt. Als noch weiterer Vorteil findet bei der Plasma-Vorbehandlung auch eine Bekeimung der Folienoberfläche der Trägerfolie mit Targetatomen, wie beispielsweise Ti, Cu, Al oder Cr, statt, was ebenfalls zu einer Haftungsverbesserung des Metalls an nicht bedruckten Stellen der Folienoberfläche der Trägerfolie führt.

Bei der Trägerfolie handelt es sich vorzugsweise um eine flexible Kunststoff-Folie, ausgewählt aus der Gruppe, bestehend aus PI, PPS, PEEK, PEK, PK, PEI, PSU, PESU, PAEK, LCP, TPU, PEN, PBT, PET (OPET, PETG, APET), PA (PA 6, PA 6.6, PA 4.6, PA 6/66, PA 12, PA 6.12), PC, COC, POM, ABS, PVC, PP, PE, ETFE, PTFE, die eine Dicke von 6 µm bis 700 µm aufweisen. Bei der Trägersubstanz handelt es sich um Papier mit einer Dicke von 30 g/m² bis 200 g/m² oder Aluminium-Folien mit einer Dicke von 8 µm bis 100 µm sowie Spinnvliese, Stapelfaservliese und SMS-Vliese, die aus folgenden Polymeren PP, PET, PA und PPS hergestellt wurden, sowie Viskosevliese, die alle eine Dicke von 20 g/m² bis 500 g/m² aufweisen. Die oben genannten Materialien sind insbesondere für eine vollflächige Bedampfung geeignet.

Außerdem können die vorstehend genannten Folien noch zusätzlich strukturiert sein (3D). Diese Strukturierung kann durch Bürsten, Schleifen und/oder thermisches Prägen in die Folien sowie durch eine Prägung in einen noch nicht ausgehärteten Lack, der auf die Folie aufgetragen wurde, mittels thermischer, ionischer oder UV-Härtung (radikalisch oder kationisch) ausgeführt werden.

Für die Herstellung der Mehrschichtensysteme können die einzelnen Trägermaterialien aus unterschiedlichen Lagen, wie unterschiedlichen Polymerfolien, wie oben genannt, aber auch aus der Kombination Folien/Papier oder Folien/Vliese und ähnlichen Kombinationen aufgebaut sein. Ebenso kann sich eine bereits bedampfte Schicht oder eine Metallfolie im Trägermaterial befinden.

Für die partielle metallische Bedampfung eignen sich als Trägerfolien insbesondere Polymere ausgewählt aus der Gruppe, bestehend aus PI, PPS; PEEK, PEK, PK, PEI, PSU, PESU, PAEK, LCP, TPU, PEN, PBT, PET (OPET, PETG, APET), PA (PA 6, PA 6.6, PA 4.6, PA 6/66, PA 12, PA 6.12), PC, COC, POM, ABS, PVC, PP, PE, ETFE, PTFE, die eine Dicke von 6 µm bis 700 µm aufweisen.

Auch hier können für die Herstellung der Mehrschichtensysteme die einzelnen Trägermaterialien aus unterschiedlichen Lagen, wie unterschiedlichen Polymerfolien, wie oben genannt, aber auch aus der Kombination Folien/Papier oder Folien/Vliese und dergleichen Kombinationen aufgebaut sein. Ebenso kann sich eine bereits bedampfte Schicht oder eine Metallfolie im Trägermaterial befinden. Die partiell bedampfte Schicht befindet sich dabei vorzugsweise auf der glatten Polymerseite.

Die Musterschicht und ggf. die Verstärkungsschicht bilden vorzugsweise Muster, wie z.B. Bahnen, aus Metall, wobei diese entsprechend einer Variante der Erfindung zumindest im wesentlichen aus Cu bestehen.

Die Trägerfolie weist eine Dicke von 6 µm bis 700 µm, vorzugsweise von 12 µm bis 100 µm, insbesondere bevorzugt von 15 µm bis 50 µm auf.

Bei einer Musterschicht, die nachträglich mit einer Verstärkungsschicht versehen wird, hat die Musterschicht bevorzugt eine Dicke von wenigstens ungefähr 0,05 µm bis 1 µm, vorzugsweise 0,2 µm, insbesondere 0,4 µm.

Die Musterschicht ggf. zusammen mit der Verstärkungsschicht hat/haben vorzugsweise ggf. zusammen eine Dicke von 1 µm bis zu etwa 50 µm, vorzugsweise um 2 µm bis 35 µm, insbesondere 3 µm bis 15 µm.

Vorzugsweise Dicken der reinen Verstärkungsschicht in Abhängigkeit vom jeweiligen Herstellungsverfahren sind bei der partiellen Metallisierung der Trägerfolie und Nachverstärkung durch chemische oder galvanische Prozesse etwa 1 µm bis 25 µm, insbesondere 1 µm bis 5 µm und speziell 2 µm bis 3 µm, und bei der vollflächigen Grundbeschichtung mit metallischen Material (insbesondere ca. 0,2 µm bis 0,4 µm Schichtdicke) mit Nachverstärkung und Differenzätzen ca. 2 µm bis 25 µm, wobei ein Ätzresist mit einer Dicke von z.B. etwa 2 µ bis 3 µm verwendet wird.

Die Musterschicht ggf. zusammen mit der Verstärkungsschicht weist entsprechend bevorzugter Ausgestaltungen der Erfindung eine Struktur auf, die von Metallisierung freie Bereiche mit einer Breite von weniger als ca. 150 µm enthält. Dies bedeutet z.B., dass die Musterschicht ggf. zusammen mit der Verstärkungsschicht, wenn sie Leiterbahnen bildet/bilden, diese Leiterbahnen einen Abstand von weniger als ca. 150 µm aufweisen.

Die strukturierte(n) Schicht(en) besteht(en) aus Metallen, bevorzugt aus Cu, Al, Fe, Ag, Au, Ni, Cr, Metallverbindungen, bevorzugt TiO₂, CrOx, ZnS, ITO, FTO, ATO, ZnO, Al₂O₃, SiOₓ, Legierungen, bevorzugt Cu-Al, Cu-Zn sowie Isolatoren, wie organischen Substanzen und deren Verbindungen (Farb- und Lacksysteme), z.B. Epoxy-, Polyester-, Kolophonium-, Acrylat-, Alkyd-, Melamin-, PVA-, PVC-, Isocyanat-, Urethansysteme, die sowohl thermisch als auch UV-härtend sein können.

Das bevorzugte Verfahren wird wie folgt durchgeführt (einzeln oder kombiniert):
- Reinigen und Bekeimen der Trägerfolie oder Trägersubstanz durch Plasmavorbehandlung im Vakuum,
- partielle Metallisierung einer Trägerfolie oder Trägersubstanz, die vorzugsweise aus Kunststoff besteht, beispielsweise mit Cu, wobei vor der Bekeimung eine lösliche Farbe (Waschfarbe) aufgetragen wird,
- Tief- oder Flexodruck einer Silberleitpaste auf eine Kunststoff-Folie,
- Tief- oder Flexodruck eines leitfähigen Startlacks für die Galvanik,
- Tief- oder Flexodruck eines Primers als Haftvermittler für Metallisierung auf definierten Bereichen der Folie (Strukturierung durch stärker haftende Bereiche),
- ein rückseitiger Isolationsdruck, ein Silberdruck und/oder eine Kaschierung sind denkbar und unter Umständen wünschenswert

Damit lassen sich metallische Schichten oder Schichtkombinationen beispielsweise aus Cu erzeugen, deren Dicke deutlich über 0,2 µm und deren Pitchabstände unter 0,5 mm liegen.

Wesentliche Vorteile der einzelnen Varianten und Ausgestaltungen der erfindungsgemäßen metallisierten Folien und deren Herstellungsverfahren sind gegenüber vorbekanntem eine Reduzierung der Produktionskosten um 20 % und sogar bis zu 50 %, die Verwendung vorhandener technischer Einrichtungen und bekannter Systeme, ökologische Vorteile und Herstellbarkeit in großen Mengen.

In den nachfolgenden Beispiele wird die Erfindung noch eingehender mit besonderen Anwendungsformen beschrieben.

### Beispiel 1

Für Anwendungen, bei denen geringere Leitfähigkeiten benötigt werden, wie z.B. Leiterplatten, die Signalströme übertragen oder Antennen, im Bereich der Hochfrequenz von über 500 MHz arbeiten, sind z.T. dünnere Cu-Schichten ausreichend. Diese sind sehr kostengünstig über eine partiell Cu-metallisierte Folie herstellbar. Die Cu-Dicke beträgt vorzugsweise 0,1 µm bis 0,5 µm Cu und die verwendete PET-Folie ist vorzugsweise 36 µm bis 100 µm dick.

Für die Herstellung einer partiell bedampften Folie, die eine geringe Leitfähigkeit aufweisen soll, wird eine 50 µm dicke PET-Folie verwendet, auf die mit löslicher Farbe eine Struktur aufgedruckt wird. Die so bedruckte Folie wird mit Cu in einer Dicke von ca. 0,1 µm bis 0,5 µm unter gleichzeitiger Bekeimung bedampft. Anschließend wird die löslich Farbe samt dem darüber liegenden Cu gelöst. An den zuvor nicht mit löslicher Farbe bedruckten Bereichen verbleibt Cu samt Bekeimung auf der Folie.

### Beispiel 2

Durch die Kombination der Art und Anzahl von Schichten bei vollflächig mehrfach bedampften Trägerfolien oder -substraten ist es möglich bestimmte Wellenlängen des Lichts durchzulassen oder zu sperren. Beispielsweise wird mit einer vollflächig mehrfach bedampften ETFE-Folie die gezielte Selektion von Strahlung, z.B. Reflexion von sichtbarer Strahlung oder Wärmestrahlung ermöglicht.

Für die Herstellung eines solchen Mehrschichtensystems wird als Substrat eine 200 µm dicke ETFE-Folie verwendet. Auf diese Folie wird als Metallschicht unter gleichzeitiger Bekeimung eine 0,1 µm bis 0,2 µm dicke Al-Schicht aufgedampft. Dann kann eine Oxidschicht ebenfalls unter gleichzeitiger Bekeimung aufgesputtert werden, die aus 0,01 µm bis 0,2 µm ITO besteht. Diese beiden Schritte können mehrfach wiederholt werden.

### Beispiel 3

Mit strukturierten Mehrschichtensystemen, die Schichten aufweisen, die verschiedene Materialien in einer Ebene besitzen, ist es beispielsweise möglich, unterschiedliche Leitfähigkeiten oder optische Effekte in einer Ebene zu erzeugen, die bei Sicherheitsmerkmalen eine weitere (höhere) Sicherheitsstufe bedeuten. Eine weitere Einsatzmöglichkeit besteht für die Identifikationsantennen (Qualitätskontrolle im Automobilbau) oder RF-Antennen, die der Quellensicherung dienen. Hier kann durch das "gezielte Auffüllen mit einem dielektrischen Material" zwischen den Leiterbahnen der Antenne, die Antenne kapazitiv so eingestellt werden, dass man sich die Bestückung mit einem Kondensator oder eine aufwendigere Parallellage erspart.

Ein strukturiertes Mehrschichtsystem mit verschiedenen Materialien in einer Ebene besteht aus einer 100 µm dicken PET-Folie, auf die im Positivdruck eine lösliche Farbe gedruckt wird. Anschließend wird als Metallschicht unter gleichzeitiger Bekeimung 0,2 µm Cu gedampft und danach gewaschen. Auf diese Schicht wird im Negativdruck eine Lösliche Farbe (Waschfarbe) aufgetragen. Darauf wird eine Oxidschicht aus SiOₓ unter gleichzeitiger Bekeimung in einer Dicke von 0,2 µm gesputtert und anschließend die Lösliche Farbe (Waschfarbe) durch Waschen von den nicht mit Metall besetzten Stellen entfernt.

### Beispiel 4

Für Anwendungen, bei denen geringere Leitfähigkeiten benötigt werden, wie z.B. Leiterplatten, die Signalströme übertragen oder Antennen, im Bereich der Hochfrequenz von über 500 MHz arbeiten, sind z.T. dünnere Cu-Schichten ausreichend.

Für diesen Anwendungsbereich wird eine PET-Folie verwendet, die vorzugsweise 50 µm dick ist, und auf der eine aufgedampfte metallische Schicht ohne Vorbehandlung nicht haften würde.
In einem ersten Verfahrensschritt wird ein gut haftender Metallisierungsprimer in einer Dicke von ca. 1 µm bis 5 µm aufgedruckt (Struktur im Positivdruck). Die so bedruckte Folie wird mit Cu in einer Dicke von 0,1 µm bis 3 µm unter gleichzeitiger Bekeimung einfach bzw. mehrfach bedampft. Anschließend wird das Cu mechanisch von den nicht mit Primer bedruckten Bereichen der Folie entfernt.

Im Rahmen der Erfindung sind ferner Maßnahmen enthalten, um die Verankerung der Metallisierung (Musterschicht) auf dem Substrat sowie ggf. die Haftung deren metallischen Schichten (Musterschicht und Verstärkungsschicht) untereinander zu verbessern. Hierzu eignen sich besonders Cr, Al, Ag, Ti, Ni, Cu, TiOₓ, SiOₓ, CrOₓ.

Durch höhere Aufdampfraten und/oder galvanische Verstärkungen lassen sich die erreichbaren Dicken der metallischen Schicht(en), wie etwa Leiterbahnen, weiter erhöhen. Von Vorteil sind ferner Verbesserungen der partiellen Entfernung der Schicht, soweit diese erforderlich ist, und der gesamten Produktionsumgebung, wie z.B. eine Reinraumfertigung. Erforderlichenfalls können auch Produktionshilfsmittel, wie die diversen Resiste und Lacke, Primer, löslichen Farben (Waschfarbe), Leitlack optimiert werden. Das Aufbringen der Metallisierung der Musterschicht kann beispielsweise mittels bekannter Aufdampftechniken, einschließlich normale Verdampfertechniken und Mehrschichtaufdampfen, erfolgen. Für die Verankerungstechnologie der Metallisierung der Trägerfolie können Plasmarezepturen insbesondere hinsichtlich der Bekeimung und Aktivierung optimiert werden. Die Demetallisierung ermöglicht Variationen u.a. bei der Auswahl der löslichen Farben (Waschfarbe), Hochdruckeinheit, Waschtrommel, Strippereinheit, usw. Bei einer Anwendung von Tiefdruck lassen sich der Tiefdruckzylinder, Auftragswerk und die lösliche Farbe (Waschfarbe) anpassen. Leitlacke können leitfähige Pigmente oder Polymere aufweisen. Entsprechende Maßnahmen sind in Kombination mit den vorstehend konkret offenbarten Merkmalen Bestandteil der vorliegenden Erfindung, auch wenn sie für sich bereits aus dem Stand der Technik bekannt sein sollten.

## Patentansprüche

1. Verfahren zur Herstellung einer partiell metallisierten Folie als Faden, Streifen oder Patch für Banknoten, Wertpapiere und Kreditkarten, als RF-Antenne für Transponder, Smart Cards, Smart Labels, Tags, als RF-Antenne in Diebstahletiketten, als Kontrolletiketten für die Qualitätssicherung, **dadurch gekennzeichnet, dass**
auf eine Trägerfolie mit einer löslichen Farbe (Waschfarbe), einer pigmentierten Farbschicht, einer reinen Pigmentschicht oder Pigmenten in Suspension ein Muster aufgedruckt wird,
anschließend die vorbehandelte Trägerfolie im Vakuum mittels einer Plasmabehandlung gereinigt und ggf. gleichzeitig mit Targetatomen bekeimt wird,
dann die so vorbehandelte Trägerfolie entweder mit einem Metall, einer Metallverbindung oder einer Legierung bedampft wird und ein strukturiertes Muster **dadurch** erzeugt wird,
dass die Farbe oder Pigmentschicht durch einen mechanischen Waschvorgang entfernt wird, wobei das gewünschte Muster erhalten wird und
die Musterschicht durch chemischen, physikalischen oder galvanischen Materialauftrag unter Bildung einer Verstärkungsschicht nachverstärkt wird.

2. Verfahren zur Herstellung einer metallisierten Folie nach Anspruch 1 mit mehrschichtigem Aufbau, **dadurch gekennzeichnet, dass**
die Verfahrensschritte der Plasmabehandlung im Vakuum unter gleichzeitiger Bekeimung mit Targetatomen und der Metallbedampfung 2 bis n-Mal wiederholt werden, wobei die Strukturen der einzelnen Schichten durch partielles oder vollflächiges Bedampfen mit dem Metall, der Metallverbindung oder der Legierung erzeugt werden und jede strukturierte Schicht unterschiedliche Materialien in der gleichen Schicht aufweisen kann und
die Targetatome für die Bildung der einzelnen Bekeimungsschichten identisch oder verschieden sein können.

3. Verfahren nach Anspruch 2, **dadurch gekennzeichnet, dass**
zwei Strukturen aus unterschiedlichen Materialien in derselben Ebene der Schicht hergestellt werden können.

4. Verfahren nach einem der Ansprüche 1 bis 3, **dadurch gekennzeichnet, dass** als Metalle Cu, Al, Fe, Ag, Cr, Ni, Zn, als Metallverbindungen TiO₂, CrOₓ, ZnS, ITO, FTO, ATO, ZnO, Al₂O₃, SiOₓ, als Legierungen Cu-Al, Cu-Zn, eingesetzt werden.

5. Verfahren nach einem der Ansprüche 1 bis 4, **dadurch gekennzeichnet, dass** die aufgedampfte metallische Schicht eine Dicke von 0,01 µm bis 3,0 µm, vorzugsweise 0,1 µm bis 1,0 µm, besonders bevorzugt 0,2 µm bis 0,4 µm aufweist.

6. Verfahren nach einem der Ansprüche 1 bis 5, **dadurch gekennzeichnet, dass** als Targetatome Metalle oder Metalloxide ausgewählt werden aus der Gruppe bestehend aus Cr, Al, Ag, Ti, Cu, Ni, SiOₓ, CrO_{X}, TiOₓ.

7. Verfahren nach einem der Ansprüche 1 bis 6, **dadurch gekennzeichnet, dass** die Targetatome in einer Dicke von 0,2 nm bis 50 nm aufgebracht werden.

8. Verfahren nach einem der Ansprüche 1 bis 7, **dadurch gekennzeichnet, daß** die Trägerfolie aus der Gruppe bestehend aus PI, PPS, PEEK, PEK, PK, PEI, PSU, PESU, PAEK, LCP, TPU, PEN, PBT, PET (OPET, PETG, APET), PA (PA 6, PA 6.6, PA 4.6, PA 6/66, PA 12, PA 6.12), PC, COC, POM, ABS, PVC, PP, PE, PTFE, ETFE ausgewählt wird und eine Dicke von 6 µm bis 700 µm aufweisen.

9. Verfahren nach einem der Ansprüche 1 bis 8, **dadurch gekennzeichnet, dass** die Trägerfolie eine Dicke von 6 µm bis 700 µm, vorzugsweise 12 µm bis 100 µm, insbesondere bevorzugt 15 µm bis 50 µm aufweist.

10. Verfahren nach einem der Ansprüche 1 bis 9, **dadurch gekennzeichnet, dass** das Substrat aus der Gruppe bestehend aus Papier, Aluminum-Folie, Spinnvliese, Stapelfaservliese und SMS-Vliese, die aus folgenden Polymeren PP, PET, PA und PPS hergestellt wurden, sowie Viskosevliese, die alle eine Dicke von 20 g/m² bis 500 g/m² aufweisen, ausgewählt wird.

11. Verfahren nach einem der Ansprüche 1 bis 10, **dadurch gekennzeichnet, dass** die strukturierte Schicht zusammen mit der Verstärkungsschicht eine Dicke von 1 µm bis 50 µm, vorzugsweise von 2 µm bis 35 µm, insbesondere bevorzugt von 3 µm bis 15 µm aufweist.

## Claims

1. Method for producing a partially metallized film as threads, strips or patches for bank notes, securities and credit cards, RF antennas for transponder, smart cards, smart labels, tags, as RF antennas in anti-theft labels, as control labels for quality assurance, **characterized in that**
a supporting film is imprinted with a soluble ink (washable ink), a pigmented lacquer layer, a pure pigment layer or a pigment in suspension to form a structured pattern;
afterwards the pre-treated supporting film is cleaned in a vacuum by means of plasma treatment and simultaneously initiated with target atoms;
the thus pre-treated supporting film is either vapor-deposited with a metal, a metal composition or an alloy and a structured pattern is produced in such a manner that
the soluble ink or pigmented layer is removed by a mechanical washing procedure, whereby the desired structured pattern is obtained; and
the structured layer is strengthened through chemical, physical or galvanic material application to form a reinforcing layer.

2. Method for producing a partially metallized film according to claim 1 with a multilayer structure, **characterized in that**,
the steps of plasma treatment under vacuum and simultaneous initiation with target atoms and the metal vapor deposition are repeated two or more times, whereby the structures of each layer formed by partially or fully vapor-depositing with the metal, the metal composition or the alloy are produced and each structured layer comprises structures made of different materials in the same level of the structure; and
the target atoms for forming the individual initiation layers can be identical or different.

3. Method according to claim 2, **characterized in that**
two structures made from different materials can be manufactured in the same level of the layer.

4. Method according to one of the claims 1 to 3, **characterized in that** all metals Cu, Al, Fe, Ag, Cr, Ni, Zn, are used as metal compositions TiO₂, CrOₓ, ZnS, ITO, FTO, ATO, ZnO, Al₂O₃, SiOₓ, as alloys Cu-Al, Cu-Zn.

5. Method according to one of the claims 1 to 4, **characterized in that** the vapor-deposited metallic layer has a thickness of 0.01 µm to 3.0 µm, preferably 0.1 µm to 1.0 µm, and especially preferred 0.2 µm to 0.4 µm.

6. Method according to one of the claims 1 to 5, **characterized in that** as target atoms metals or metallic oxides are selected from the group consisting of Cr, Al, Ag, Ti, Cu, Ni, SiOₓ, CrOₓ, TiOₓ.

7. Method according to one of the claims 1 to 6, **characterized in that** the target atoms are applied at a thickness by 0.2 µm to 50 nm.

8. Method according to one of the claims 1 to 7, **characterized in that** the supporting film is selected from the group consisting of PI, PPS, PEEK, PEK, PK, PEI, PSU, PESU, PAEK, LCP, TPU, PEN, PBT, PET (OPET, PETG, APET), PA (PA 6, PA 6,6, PA 4,6, PA 6/66, PA 12, PA 6.12), PC, COC, POM, ABS, PVC, PP, PE, PTFE, ETFE, at a thickness of 6 µm to 700 µm.

9. Method according to one of the claims 1 to 8, **characterized in that** the supporting film has a thickness of 6 µm to 700 µm, preferably 12 µm to 100 µm, especially preferred of 15 µm to 50 µm.

10. Method according to one of the claims 1 to 14, **characterized in that** the substrate is selected from the group consisting of paper, aluminium film, spunbounded fabrics, staple-fiber fabrics, and SMS fabrics, which have been made from the following polymers PP, PET, PA and PPS as well as viscose fabrics, which all have a thickness of 20 g/m² to 500 g/m².

11. Method according to one of the claims 1 to 10, **characterized in that** the structured layer together with the reinforcement layer has a thickness from 1 µm to 50 µm, preferably of 2 µm to 35 µm, especially preferred of 3 µm to 15 µm.

## Revendications

1. Procédé de fabrication d'une feuille partiellement métallisée servant de fil, de bande ou de patch pour des billets de banque, des titres et des cartes de crédit, d'antenne RF pour des transpondeurs, des Smart Cards, des Smart Labels, des tags, d'antenne RF dans des étiquettes anti-vol, d'étiquettes de contrôle pour l'assurance qualité, **caractérisé en ce que**
un motif est imprimé sur une feuille support avec un colorant soluble dans l'eau, une couche de colorant pigmentaire, une couche de pigments pures ou avec des pigments en suspension,
la feuille support préalablement traitée sous vide au moyen d'un traitement au plasma est ensuite nettoyée et, le cas échéant, simultanément ensemencée d'atomes cibles,
la feuille support ainsi traitée préalablement est ensuite revêtue d'un métal, d'une combinaison de métaux ou d'un alliage par évaporation, ce qui a pour effet de produire un motif structuré,
le colorant ou la couche de pigments est éliminé à l'aide d'un processus de lavage mécanique, le motif souhaité étant conservé et
la couche à motif est ultérieurement renforcée grâce à un apport chimique, physique ou galvanique de matière qui forme une couche de renfort.

2. Procédé de fabrication d'une feuille métallisée suivant la revendication 1 avec une structure multicouche, **caractérisé en ce que**
les étapes de procédé du traitement au plasma sous vide et de l'ensemencement simultané avec des atomes cibles, ainsi que du revêtement de métal par évaporation sont répétées 2 à x fois, les structures des différentes couches étant réalisées par revêtement par évaporation du métal, de la combinaison de métaux ou de l'alliage de parties ou de l'ensemble de la surface, chaque couche structurée pouvant présenter des matériaux différents dans la même couche et
**en ce que** les atomes cibles pour la formation des différentes couches d'ensemencement peuvent être identiques ou différents.

3. Procédé suivant la revendication 2, **caractérisé en ce que** deux structures peuvent être fabriquées dans des matières différentes sur le même plan de la couche.

4. Procédé suivant une des revendications 1 à 3, **caractérisé en ce que** l'on utilise Cu, Al, Fe, Ag, Cr, Ni, Zn comme métaux, TiO₂, CrOₓ, ZnS, ITO, FTO, ATO, ZnO, Al₂O₃, SiOₓ comme combinaisons de métaux, Cu-al, Cu-Zn comme alliages.

5. Procédé suivant une des revendications 1 à 4, **caractérisé en ce que** la couche métallique appliquée par évaporation présente une épaisseur comprise entre 0,01 µm et 3,0 µm, de préférence entre 0,1 µm et 1,0 µm, épaisseur préférée en particulier de 0,2 µm à 0,4 µm.

6. Procédé suivant une des revendications 1 à 5, **caractérisé en ce que** les atomes cibles, métaux ou oxydes de métaux sont choisis parmi un groupe composé de Cr, Al, Ag, Ti, Cu, Ni, SiOₓ, Croiₓ, TiOₓ.

7. Procédé suivant une des revendications 1 à 6, **caractérisé en ce que** les atomes cibles appliqués forment une épaisseur comprise entre 0,2 nm et 50 nm.

8. Procédé suivant une des revendications 1 à 7, **caractérisé en ce que** la feuille support est choisie parmi un groupe composé de PI, PPS, PEEK, PEK, PK, PEI, PSU, PESU, PAEK, LCP, TPU, PEN, PBT, PET, (OPET, PETG, APET), PA (PA 6, PA 6.6, PA 4.6, PA 6/66, PA12, PA 6.12), PC, COC, POM, ABS, PVC, PP, PE, PTFE, ETFE et présente une épaisseur comprise entre 6 µm et 700 µm.

9. Procédé suivant une des revendications 1 à 8, **caractérisé en ce que** la feuille support présente une épaisseur comprise entre 6 µm et 700 µm, de préférence entre 12 µm et 100 µm, épaisseur préférée en particulier de 15 µm à 50 µm.

10. Procédé suivant une des revendications 1 à 9, **caractérisé en ce que** le substrat est choisi parmi le groupe composé de papier, de feuille en aluminium, de non-tissé, de non-tissé en fibre artificielle discontinue et de non-tissé SMS, fabriqués à base des polymères suivants PP, PET, PA et PPS, ainsi que des non-tissés en viscose, qui présentent tous une épaisseur comprise entre 20g/m² et 500 g/m².

11. Procédé suivant une des revendications 1 à 10, **caractérisé en ce que** la couche structurée présente avec la couche de renfort, une épaisseur comprise entre 1 µm et 50 µm, de préférence entre 2 µm et 35 µm, épaisseur préférée en particulier de 3 µm à 15 µm.
